# EUROPEAN PATENT APPLICATION

(11) **EP 2 587 174 A1**
(43) Date of publication of application: **01.05.2013**
(21) Application number: 12190578.0
(22) Date of filing: 30.10.2012
(51) Int. Cl.: F24F 1/00, F24F 3/044, H05K 7/20

(54) **Climate control machine**

(30) Priority: 31.10.2011 IT PD20110346
(71) Applicant: Emerson Network Power S.R.L., 35028 Piove di Sacco (PD) (IT)
(72) Inventor: Ranzato, Alberto, 35020 Legnaro PD (IT)
(74) Representative: Modiano, Micaela Nadia

(57) **Abstract**

A climate control machine (10) of the type that has a function for cooling by introducing external air, which comprises a cabinet (11) with heat exchange means (12), proximate to which there are one or more fans (13) which are adapted to aspirate air from a first shutter (14) for the inflow of air that arrives from the internal environment (AI), or from a second shutter (15) for the inflow of air that arrives from the outside (AE) for the "free cooling" function, or from both shutters (14, 15).

The heat exchange means (12) are interposed between the first shutter (14) and the one or more fans (13), whereas the space (16) between the second shutter (15) and the fans (13) is free from the space occupation caused by the heat exchange means (12).

## Description

The present invention relates to a climate control machine of the type that has a function for cooling by introducing external air.

Server rooms, and in general any site that contains numerous electronic devices and racks for supporting a plurality of servers, electric and electronic instruments and the like, generally enclosed within adapted ventilated cabinets, require continuous climate control that is adapted to prevent the heat originating from the computers and from the electronic instruments themselves from accumulating and thus determining temperatures that are so high as to damage the internal components of such electronic instruments and the like.

Nowadays, in order to overcome these drawbacks, climate control plants are generally installed in server rooms, and are increasingly widespread particularly in environments installed on a raised floor.

In fact the space between the ground and the raised floor can be easily fitted out not only for the distribution of cables for connecting and powering the racks and computers, but also as a plenum space, i.e. as an area for the passage of conditioned air, fed in by one or more cooling and climate control machines, such plenum spaces conveying the air, by way of floor grilles, either to the overlying environment or directly into the rack cabinets.

Machines for such climate control, both underfloor and directly in the environment, are generally constituted by a cabinet within which heat exchange means are arranged below which there are, generally arranged below the raised floor or above the heat exchange means, a plurality of fans which are designed to aspirate air from the cabinet so that it crosses the heat exchange means and is then pushed, treated, into the underfloor space or directly into the environment or into a plenum space for conveyance of the treated air.

A particular type of such climate control machines is provided with the function known as "free cooling".

The "free cooling" option is based on the capacity of the climate control machine to use, in order to condition an environment, air originating from the outside when it has a lower enthalpy value than the air of the internal environment.

Free cooling enables the user to save a considerable amount of energy, in addition to a more healthful management of the air of the internal environment which, with the activation of free cooling, is conveniently exchanged.

Such climate control machines with the free cooling function generally have a cabinet with two shutters, a first shutter for the inflow of air that arrives from the internal environment, and a second shutter for the inflow of air that arrives from the outside for the free cooling function.

The climate control machines with free cooling known today are configured so that both the air that enters from the first shutter and the outside air that enters from the second shutter must cross the heat exchange means, generally a bank of finned tubiform bundles, before reaching the ventilation means which diffuse the air directly into the environment or under a raised floor.

If the passage of the internal air entering from the first shutter through the heat exchange means is necessary in order to provide for the desired conditioning of such internal air, then the passage through the heat exchange means of the outer air in the free cooling function, air which does not have to be conditioned, leads to a disadvantageous loss of load with consequent consumption of electric power to enable the fans to supply the required flow and overcome the aforementioned load losses.

The aim of the present invention is to provide a climate control machine of the type that has a function for cooling by introducing external air and is capable of overcoming the aforementioned drawback of conventional machines.

Within this aim, an object of the invention is to provide a climate control machine of the type that has a function for cooling by introducing external air, which has better yield and overall efficiency than conventional machines.

Another object of the invention is to provide a climate control machine that can be installed both with airflow directed into the environment, and with airflow directed under a raised floor.

Another object of the invention is to provide a climate control machine of the type that has a function for cooling by introducing external air, which can be made using known systems and technologies.

This aim and these and other objects which will become more apparent hereinafter are all achieved by a climate control machine of the type that has a function for cooling by introducing external air, which comprises a cabinet inside which there are heat exchange means, proximate to which there are one or more fans adapted to aspirate air
- from a first shutter for the inflow of air that arrives from the internal environment,
- or from a second shutter for the inflow of air that arrives from the outside for what is called "free cooling" function by introducing external air,
- or from both said first shutter and said second shutter,
said climate control machine being **characterized in that** said heat exchange means are interposed between said first shutter and said one or more fans, the space between said second shutter and said fans being free from the space occupation caused by said heat exchange means.

Further characteristics and advantages of the invention will become more apparent from the description of two preferred, but not exclusive, embodiments of the climate control machine according to the invention, illustrated by way of non-limiting example in the accompanying drawings wherein:
Figure 1 is a schematic side view of a machine according to the invention in a first embodiment thereof and in a first mode of use;
Figure 2 is a schematic side view of the machine according to the invention in Figure 1, in a second mode of use;
Figure 3 is a schematic side view of a machine according to the invention in a second embodiment thereof and in a first mode of use;
Figure 4 is a schematic side view of the machine in Figure 3, in a second mode of use.

With reference to the figures, a climate control machine of the type that has a function for cooling by introducing external air is generally designated in the first embodiment thereof with the reference numeral 10.

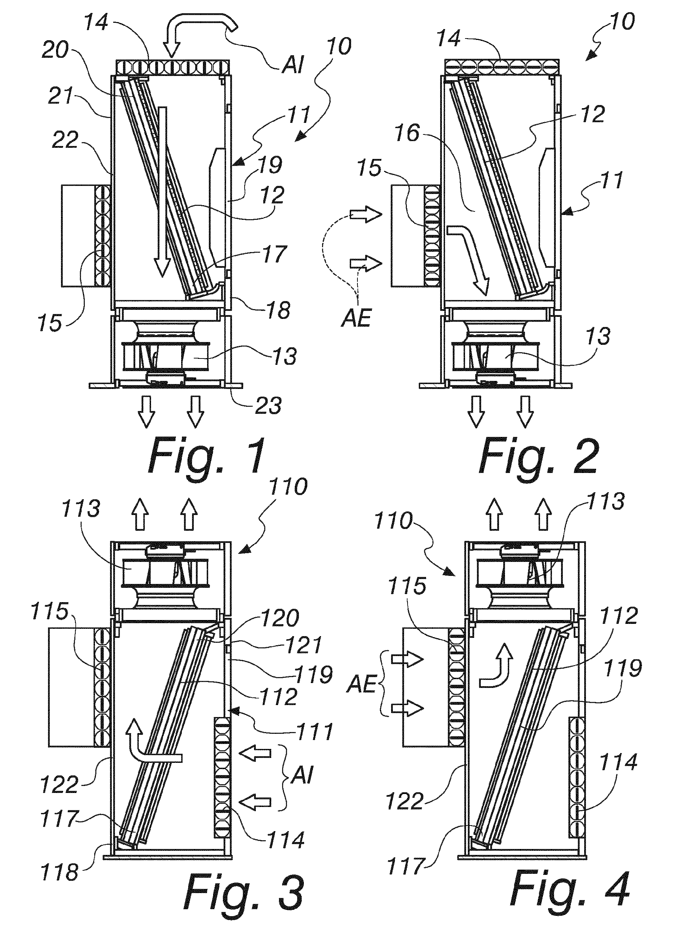

Such climate control machine 10 comprises a cabinet 11 inside which there are heat exchange means 12, proximate to which there are one or more fans 13 adapted to aspirate air
- from a first shutter 14 for the inflow of air that arrives from the internal environment, designated with the arrow 'AI' in Figure 1,
- or from a second shutter 15 for the inflow of air that arrives from the outside, designated with the arrow 'AE' in Figure 2, for the "free cooling" function by introducing external air,
- or from both the first shutter 14 and the second shutter 15.

The particularity of the climate control machine 10 according to the invention consists in that the heat exchange means 12 are interposed between the first shutter 14 and the one or more fans 13, so that conveniently the internal air AI to be conditioned crosses heat exchange means 12, while the space 16, within the cabinet 12, between the second shutter 15 and the fans 13, is free from the space occupation caused by the heat exchange means 12, and in this manner the external air AE can flow directly from the second shutter 15, for free cooling, to the fans 13 without crossing the heat exchange means 12, with consequent advantages in terms of prevented load loss and energy savings for the fans with respect to conventional machines.

Figures 1 and 2 show in schematic form a first embodiment of the climate control machine 10 according to the invention, in which the heat exchange means 12 are constituted by a bank of finned tubes, known per se, which is arranged diagonally within the cabinet 11, with the lower edge 17 proximate to the lower part 18 of first, front, panels 19 of the cabinet 11, and with the upper edge 20 proximate to the upper part 21 of second, rear, opposite panels 22 of the same cabinet 11.

In such first embodiment, the fans 13 are arranged below the cabinet 11 so as to aspirate air from it in order to inject it below a raised floor 23.

The first shutter 14 is arranged above the heat exchange means 12, so as to define the top of the cabinet 11, or incorporated in a plenum space or other form of duct, not shown, for the passage of air, or in front of them at the first, front, panels, in a substantially equivalent solution which is not shown for the sake of simplicity.

The second shutter 15 is defined at the second, rear, panels 22 below the upper edge 20 of the heat exchange means 12.

Figure 1 shows, schematically, the operation with treatment of internal air AI, in which the internal air AI enters from the first shutter 14, which is open, crosses the heat exchange means 12 and exits under the floor through the fans 13; the second shutter 15 is closed.

Figure 2 shows, schematically, the free cooling operation, in which the external air AE enters from the second shutter 15, which is open, does not cross the heat exchange means 12, but instead is aspirated directly toward the fans 13; the first shutter 14 is closed.

In a second embodiment of the machine according to the invention, designated in Figures 3 and 4 with the reference numeral 110, the heat exchange means 112, which are constituted as above by a bank of finned tubes, are arranged diagonally within the cabinet 111, with the lower edge 117 proximate to the lower part 118 of the rear panels 122 of the cabinet 111, and with the upper edge 120 proximate to the upper part 121 of the opposite front panels 119.

The fans 113 are arranged above the cabinet 111 so as to aspirate air therefrom in order to inject it into the environment or into an overlying associated duct.

The first shutter 114 is arranged below the heat exchange means 112, or in front of them at the front panels 119, as in Figures 3 and 4, whereas the second shutter 115 is defined at the rear panels 122 above the lower edge 117 of the heat exchange means 112.

Similarly to the above description, Figure 4 highlights the passage of the external air AE directly toward the fans 113 without crossing the heat exchange means 112.

In practice it has been found that the invention fully achieves the intended aim and objects.

In particular, with the invention a climate control machine is provided of the type that has a function for cooling by introducing external air, which has better yield and overall efficiency than conventional machines.

Moreover, with the invention a climate control machine is provided which can be installed both with airflow directed into the environment, and with airflow directed under a raised floor.

Moreover, with the invention a climate control machine is provided of the type that has a function for cooling by introducing external air, which can be made using known systems and technologies.

The invention, thus conceived, is susceptible of numerous modifications and variations, all of which are within the scope of the appended claims. Moreover, all the details may be substituted by other, technically equivalent elements. In practice the materials employed, and the contingent dimensions and shapes, may be any according to requirements and to the state of the art.

The disclosures in Italian Patent Application No. PD2011A000346 from which this application claims priority are incorporated herein by reference.

Where the technical features mentioned in any claim are followed by reference numerals and/or signs, those reference numerals and/or signs have been included for the sole purpose of increasing the intelligibility of the claims and accordingly, such reference numerals and/or signs do not have any limiting effect on the interpretation of each element identified by way of example by such reference numerals and/or signs.

## Claims

1. A climate control machine (10) of the type that has a function for cooling by introducing external air, comprising a cabinet (11) inside which there are heat exchange means (12), proximate to which there are one or more fans (13) adapted to aspirate air
- from a first shutter (14) for the inflow of air that arrives from the internal environment (AI),
- or from a second shutter (15) for the inflow of air that arrives from the outside (AE) for what is called a "free cooling" function by introducing external air,
- or from both said first shutter (14) and said second shutter (15),
said climate control machine (10) being **characterized in that** said heat exchange means (12) are interposed between said first shutter (14) and said one or more fans (13), the space (16) between said second shutter (15) and said fans (13) being free from the space occupation caused by said heat exchange means (12).

2. The climate control machine according to claim 1, **characterized in that** said heat exchange means (12) are constituted by a bank of finned tubes which is arranged diagonally within said cabinet (11), with the lower edge (17) proximate to the lower part (18) of first, front, panels (19) of the cabinet, and with the upper edge (20) proximate to the upper part (21) of second, rear, opposite panels (22) of the cabinet (11), said fans (13) being arranged below the cabinet (11) so as to aspirate air from it in order to inject it below a raised floor (23), said first shutter (14) being arranged above said heat exchange means (12) or in front of them at said first, front, panels (19), said second shutter (15) being formed at said second, rear, panels (22), below the upper edge (20) of the heat exchange means (12).

3. The climate control machine according to claim 1, **characterized in that** said heat exchange means (112) are constituted by a bank of finned tubes which is arranged diagonally within said cabinet (111), with the lower edge (117) proximate to the lower part (118) of first, rear, panels (122) of the cabinet, and with the upper edge (120) proximate to the upper part (121) of second opposite, front, panels (119) of the cabinet, said fans (113) being arranged above the cabinet so as to aspirate air from it in order to inject it into the environment or into an overlying associated duct, said first shutter (114) being arranged below said heat exchange means (112) or in front of them at said second, front, panels (119), said second shutter (115) being formed at said first, rear, panels (122), above the lower edge (117) of the heat exchange means (112).
